# FASCICULE DE BREVET EUROPEEN

(11) **EP 4 283 312 B1**
(45) Date de publication et mention de la délivrance du brevet: **31.12.2025**
(21) Numéro de dépôt: 23174894.8
(22) Date de dépôt: 23.05.2023
(51) Int. Cl.: G01R 22/06

(54) **PROCEDE DE CALCUL DE DONNEES QUALIMETRIQUES, DISPOSITIF DE QUALIMETRIE, COMPTEUR ET SYSTEME METTANT EN OEUVRE LEDIT PROCEDE**
VERFAHREN ZUR BERECHNUNG VON QUALIMETERISCHEN DATEN, GERÄT, SOWIE ZÄHLER UND SYSTEM
METHOD FOR CALCULATING QUALIMETRIC DATA, QUALIMETRIC DEVICE, AND ASSOCIATED METER AND SYSTEM

(30) Priorité: 24.05.2022 FR 2204978
(43) Date de publication de la demande: 29.11.2023
(73) Titulaire: Sagemcom Energy & Telecom SAS, 92270 Bois-Colombes (FR)
(72) Inventeur: TEBOULLE, Henri, 92500 RUEIL MALMAISON (FR); LHUILLIER, Pierre, 92500 RUEIL MALMAISON (FR); ADAM, Sylvestre, 92500 RUEIL MALMAISON (FR)
(74) Mandataire: Cabinet Le Guen Maillet

(56) Documents cités:
- CN-A- 103 425 611
- CN-A- 106 530 667
- CN-A- 107 819 778
- CN-A- 108 183 491
- CN-A- 109 218 173
- FR-A1- 2 832 502
- FR-A1- 2 977 059
- US-A1- 2012 173 032
- US-B1- 6 867 707

## Description

### DOMAINE TECHNIQUE

Au moins un mode de réalisation concerne un procédé de calcul de données qualimétriques par un dispositif de qualimétrie en communication avec un compteur d'un réseau électrique. D'autres modes de réalisation concernent un dispositif de qualimétrie, un compteur et un système mettant en œuvre ledit procédé.

### ETAT DE LA TECHNIQUE ANTERIEURE

Il est connu des compteurs intelligents, de type compteurs électriques, compteurs d'énergie thermique ou compteurs à fluides, e.g. gaz ou eau, qui comprennent des interfaces de communication permettant à un système de gestion automatisée d'effectuer une collecte à distance de données compteur, e.g. des données de consommation. Par exemple, ces compteurs intelligents comportent une (ou des) interface(s) de communication de type CPL (acronyme de « Courant Porteur en Ligne ») et/ou de type radio. Ils transmettent alors par ces interfaces de communication les données compteur, e.g. sous la forme de trames, pour une remontée de ces données de consommation, à intervalles réguliers ou non, jusqu'à un système d'information les traitant de manière centralisée. Ces données de consommation sont utilisées par le système d'information notamment pour des opérations de facturation du client consommateur par un fournisseur de service.

Il est par ailleurs connu que, dans le cadre de ses relations avec ses clients et ses fournisseurs, un distributeur d'électricité contrôle la qualité de l'énergie électrique qu'il fournit ou qui lui est livrée. Pour contrôler cette qualité, il est nécessaire de déterminer les perturbations que peut subir le signal électrique. Les surtensions et creux de tension, le papillotement (« flicker » en anglais), les variations de fréquence réseaux, les harmoniques sont des exemples de paramètres représentatifs de telles perturbations. La norme EN 61000-4-30 Classe A définit des méthodes de mesure, d'agrégation temporelle, de précision et d'évaluation à appliquer à chaque paramètre pour obtenir des données qualimétriques fiables, reproductibles et comparables. La Classe A est notamment utilisée lorsque des données précises sont nécessaires, par exemple pour des applications contractuelles qui peuvent nécessiter la vérification de la conformité à des normes, la résolution de litiges, etc.

Le dispositif PQI-D de GMC Instruments est un exemple de dispositif de qualimétrie certifié Classe A permettant d'effectuer des calculs de données qualimétriques pour les parties moyennes et hautes tensions d'un réseau de distribution. Toutefois, un tel dispositif qui est onéreux n'est pas adapté pour effectuer des calculs de données qualimétriques dans la partie basse du réseau de distribution, à savoir au plus près du consommateur final. Un autre exemple pertinent de l'état de la technique est décrit dans le document FR 2 832 502 A1.

Il est souhaitable de pallier ces différents inconvénients de l'état de la technique. Il est notamment souhaitable de proposer un procédé de relève de données qualimétriques qui permette d'obtenir des données qualimétriques au plus près du consommateur final avec un surcoût limité.

### EXPOSE DE L'INVENTION

Des procédés de calcul de données qualimétriques, un dispositif qualimétrique ainsi qu'un compteur d'un réseau électrique selon l'invention sont respectivement définis dans les revendications indépendantes 1, 5, 7 et 8. D'autres modes de réalisation de l'invention sont spécifiés dans les revendications dépendantes attenantes.

Un système comprenant un dispositif qualimétrique en communication au travers d'une liaison série avec un compteur est également décrit.

Un produit programme d'ordinateur est décrit qui comprend des instructions pour mettre en œuvre le procédé de calcul de données qualimétriques selon l'un des modes de réalisation précédent, lorsque ledit programme est exécuté par au moins un processeur. Un support de stockage est décrit qui stocke un programme d'ordinateur comprenant des instructions pour mettre en œuvre le procédé de calcul de données qualimétriques selon l'un des modes de réalisation précédent lorsque ledit programme est exécuté par au moins un processeur.

### BREVE DESCRIPTION DES DESSINS

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :
[Fig. 1] illustre schématiquement un système de relève de compteurs dans lequel les différents modes de réalisation décrits peuvent être implémentés ;
[Fig. 2] illustre schématiquement un procédé de calcul de données qualimétriques selon un mode particulier de réalisation ;
[Fig. 3] illustre schématiquement un exemple d'architecture matérielle d'un dispositif de qualimétrie selon un mode particulier de réalisation ; et,
[Fig. 4] illustre schématiquement un exemple d'architecture matérielle d'un compteur selon un mode particulier de réalisation.

### EXPOSE DETAILLE DE MODES DE REALISATION

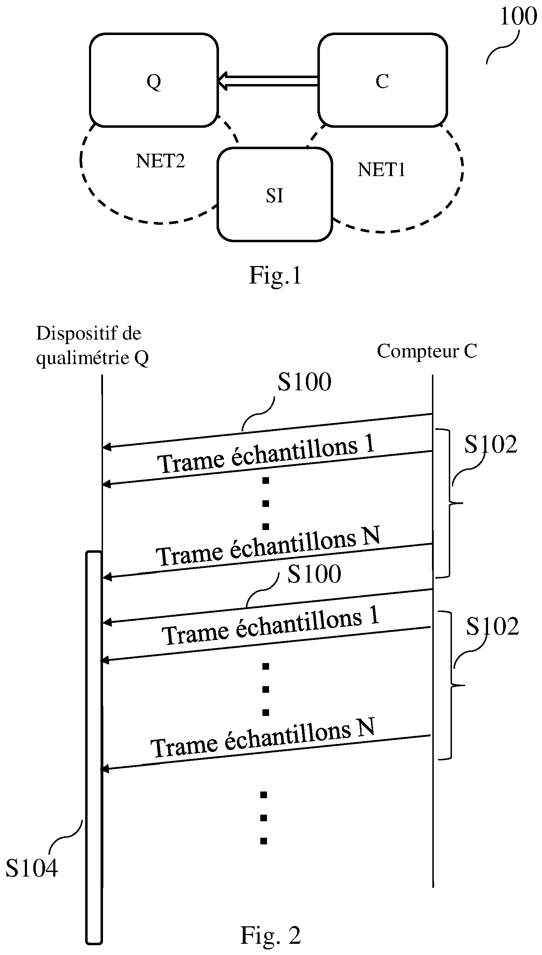

La Fig. 1 illustre schématiquement un système de relève de compteurs 100 dans lequel les différents modes de réalisation décrits ci-après peuvent être implémentés. Le système de relève de compteurs 100 est configuré pour réaliser une relève de données compteur notamment des données de consommation auprès de N compteurs intelligents C (« Smart Meters » en anglais). Sur la Fig.1, un seul compteur est représenté. Les compteurs intelligents C sont des compteurs électriques configurés pour mesurer une consommation d'électricité grâce à un logiciel de métrologie. Ces compteurs intelligents C ont la capacité de communiquer avec un système d'information SI (« Information System » en anglais) au travers d'un réseau de communication NET1 par transmission radio et/ou CPL ou en cellulaire (2G, 3G, 4G ou 5G). Ils peuvent communiquer avec le système d'information SI (« Information System » en anglais) soit directement soit par l'intermédiaire de concentrateurs de données non représentés sur la Fig. 1. Le rôle du système d'information SI est notamment de surveiller les opérations de mesure effectuées par les compteurs intelligents C.

Afin de contrôler la qualité de l'énergie électrique fournie, le distributeur d'électricité utilise un dispositif de qualimétrie Q mobile qui est alimenté en électricité directement par le réseau de distribution électrique ou par batterie et qu'il peut déplacer et relier à un compteur C particulier pendant une durée d'analyse prédéfinie, e.g. pendant une semaine. Ainsi, la qualité de l'énergie électrique fournie au point de distribution peut être vérifiée pendant cette durée. A cet effet, le dispositif de qualimétrie Q est relié au compteur C par une liaison série, e.g. un câble torsadé de type RS-485 ou RS-422 autorisant un débit de plusieurs Mbits/s. Plus précisément, un port série du dispositif de qualimétrie Q est relié par le câble à un port série du compteur C. Dans un mode de réalisation, la liaison série entre le dispositif de qualimétrie Q et le compteur C est unidirectionnelle, i.e. que des données sont transmises sous forme de trame uniquement du compteur C vers le dispositif de qualimétrie Q. Dans une variante de réalisation, la liaison série entre le dispositif de qualimétrie Q et le compteur C est bi-directionnelle. Dans ce cas, une trame d'acquittement est envoyée par le dispositif de qualimétrie Q au compteur C à chaque réception par le dispositif de qualimétrie Q d'une trame de données en provenance du compteur C.

Dans un mode de réalisation, les données sont transmises par le compteur C au dispositif de qualimétrie Q de manière asynchrone. Dans une variante de réalisation, les données sont transmises par le compteur C au dispositif de qualimétrie Q de manière synchrone. Dans ce dernier mode de réalisation, le compteur C envoie alors au dispositif de qualimétrie Q son horloge afin que le dispositif de qualimétrie Q synchronise sa propre horloge sur celle du compteur C. Que la liaison série fonctionne en mode synchrone ou asynchrone, elle le fait sur la base du protocole de communication de niveau 2 HDLC (acronyme anglais de « *High-Level Data Link Control* »). En variante, la liaison série peut utiliser le protocole par relayage de trames ou *Frame Relay* en anglais.

Le dispositif de qualimétrie Q est également configuré pour communiquer avec le système d'information SI par le biais d'un réseau de communication NET2, e.g. l'Internet. Notamment, le système d'information SI récupère auprès du dispositif de qualimétrie Q les données qualimétriques calculées. Dans d'autres modes de réalisation, le réseau de communication NET2 est un réseau de communication sans-fil, par exemple de type GPRS (« General Packet Radio Service » en anglais), UMTS / 3G (« Universal Mobile Telecommunication System » en anglais), LTE (« Long-Term Evolution » en anglais), NB-IoT (« Narrowband Internet of Things »), 2G, 4G ou 5G ou LoRa (acronyme anglais de « *Long Range »).*

La Fig.2 illustre schématiquement un procédé de calcul de données qualimétriques selon un mode particulier de réalisation. Dans ce mode de réalisation, la liaison série entre le dispositif de qualimétrie Q et le compteur C est considérée comme unidirectionnelle et asynchrone.

Lors d'une étape S100, le compteur C envoie une trame de synchronisation au dispositif de qualimétrie Q au début de chaque nouvelle période T, e.g. T=1s, de l'horloge du compteur C. Cette trame de synchronisation indique au dispositif de qualimétrie Q le début d'une nouvelle période T. Le dispositif de qualimétrie Q qui reçoit cette trame de synchronisation est alors capable de déterminer quand a réellement débuté la nouvelle période T côté compteur. En effet, il connaît par conception le décalage temporel Δt qui existe entre le début effectif de la nouvelle période T côté compteur et la réception de la trame de synchronisation. Dès lors, quand il reçoit la trame de synchronisation à un instant t, il en déduit que la période T a débuté à l'instant t-Δt côté compteur. Cette dernière information permet au dispositif de qualimétrie Q de déterminer exactement sur quelle seconde (vue de son horloge qu'il recale sur celle du compteur) sont faits les calculs de données qualimétriques à partir des échantillons de ladite seconde.

Dans un mode de réalisation particulier, la trame de synchronisation comprend dans ses données utiles (« payload » en anglais) les informations mentionnées dans le tableau ci-dessous

| Type dans la Payload | Nombre d'octets |
|---|---|
| Type de trame | 1 |
| Numéro de série du compteur | 9 |
| Données caractéristiques | 1 |
| Fréquence d'échantillonnage | 1 |
| Fréquence réseau | 2 |
| Heure UTC | 6 |

Le type de trame est spécifié sur 1 octet et indique, par exemple, quand sa valeur vaut 0 qu'il s'agit d'une trame de synchronisation. Bien entendu, il s'agit d'une simple convention.

Le numéro de série du compteur C est spécifié sur 9 octets.

Des données caractéristiques relatives au fonctionnement du compteur sont indiquées sur 1 octet. Ces données comprennent notamment les informations suivantes :
o Une information sur 1 bit représentative du type d'échantillonnage, e.g.
   ▪ 0 = nombre de trames d'échantillons fixé par période réseau
   ▪ 1 = nombre de trames d'échantillons fixé par période T, e.g. par seconde
o Une information sur 2 bits représentative du type du compteur C, e.g.
   ▪ 00 = monophasé
   ▪ 01 = triphasé sans neutre
   ▪ 10 = triphasé avec neutre
   ▪ 11 = non utilisé
o Une information sur 1 bit indiquant si le courant de neutre est ou non mesuré par le compteur C, e.g.
   ▪ 0 = mesuré
   ▪ 1 = non mesuré
o Une information sur 4 bits qui n'est pas utilisée

Ces données permettent au dispositif de qualimétrie d'interpréter des trames d'échantillons reçues par la suite.

Ainsi, dans le cas où le compteur C est triphasé sans neutre, le dispositif de qualimétrie Q sait qu'il recevra par la suite des échantillons pour chacune des trois phases mais pas pour le neutre. Il en va de même si la trame de synchronisation indique un compteur C de type triphasé avec neutre mais que le courant de neutre est indiqué comme étant « non mesuré ». Le type d'échantillonnage indique si le nombre de trames d'échantillons qui sont envoyées par la suite est fixé par période réseau (la période réseau étant égale à l'inverse de la fréquence réseau) ou par période T, e.g. par seconde. Cette information permet au dispositif de qualimétrie Q de savoir s'il doit s'attendre à un nombre N de trames d'échantillons fixe par seconde ou pas.

La fréquence d'échantillonnage du compteur C est indiquée sur 1 octet. Cette donnée est nécessaire pour que le dispositif de qualimétrie puisse faire des transformées de Fourier afin de calculer des harmoniques de tension et de courant lors de l'étape suivante.

La fréquence réseau, e.g. 50 ou 60 Hz, mesurée sur une période T précédente et appliquée sur la période T en cours est indiquée sur 2 octets. Cette donnée est nécessaire pour que le dispositif de qualimétrie puisse calculer les données qualimétriques lesquelles sont calées sur la période réseau comme indiqué dans les sections 4.4 et 4.5.2 du document EN 61000-4-30.

Optionnellement, la trame comprend l'heure de temps universel coordonné (plus connu sous la terminologie UTC) du compteur C qui est représentée sur 6 octets. Cette heure UTC est utilisée par le dispositif de qualimétrie pour horodater les données qualimétriques qu'il calcule. En variante, le dispositif de qualimétrie Q récupère l'heure UTC auprès du SI, dans le cas où celle-ci n'a pas à être transmise par le compteur dans la trame de synchronisation.

Lors d'une étape S102, le compteur C envoie sur la période T, N échantillons à la suite les uns des autres, chaque échantillon étant transmis dans une trame. Ces échantillons sont issus de la conversion analogique/numérique des signaux de tensions et de courants pour chacune des phases (dans le cas d'un signal multi-phases) et le cas échéant du neutre. Ils sont par ailleurs calibrés en gain. Ainsi, chaque trame comprend des données échantillonnées à un instant d'échantillonnage donné par le compteur C et qui ont subi une correction de calibration des gains.

Dans un mode de réalisation particulier, la trame d'échantillon comprend dans ses données utiles (« payload » en anglais) les informations mentionnées dans le tableau ci-dessous dans le cas particulier d'un signal électrique tri-phasé avec neutre. Bien entendu dans le cas d'un signal monophasé avec neutre, les données relatives aux phases 2 et 3 sont absentes et dans le cas sans mesure de neutre les données relatives au neutre sont absentes.

| Type dans la payload | Nombre d'octets |
|---|---|
| Type de trame | 1 |
| Numéro de trame | 2 |
| Tension Phase 1 | 2 |
| Courant Phase 1 | 3 |
| Tension Phase 2 | 2 |
| Courant Phase 2 | 3 |
| Tension Phase 3 | 2 |
| Courant Phase 3 | 3 |
| Courant de Neutre | 3 |

Le type de trame est spécifié sur 1 octet et indique, par exemple, quand sa valeur vaut 1 qu'il s'agit d'une trame d'échantillons. Bien entendu, il s'agit d'une simple convention. La trame comprend un numéro de trame qui prend la valeur nulle pour la première trame d'échantillon envoyée après le début de la première période T. Cette valeur est ensuite incrémentée de 1 à chaque envoi par le compteur d'une nouvelle trame. Ainsi, le dispositif de qualimétrie Q qui reçoit les trames d'échantillons peut vérifier la cohérence des trames reçues et, en cas d'incohérence, afficher un message d'erreur sur un écran du dispositif de qualimétrie Q.

Chaque échantillon de tension calibré en gain est représenté sur 2 octets.

Chaque échantillon de courant calibré en gain est représenté sur 3 octets.

Les données utiles de synchronisation et les données utiles d'échantillons sont ensuite encapsulées dans une trame HDLC avant transmission au dispositif qualimétrique Q.

Les étapes S100 et S102 sont répétées sur une prochaine période T et ce jusqu'à la fin de la durée d'analyse prédéfinie, e.g. une semaine. Ainsi, pendant chaque période T, le dispositif de qualimétrie Q collecte des échantillons envoyés par le compteur C. Lors d'une étape S104, il calcule en continu, pour chaque phase et le cas échéant pour le neutre, selon la norme EN 61000-4-30, des données qualimétriques à partir d'échantillons reçus. Des exemples de types de données qualimétriques calculées lors de l'étape S104 sont : une fréquence industrielle, une amplitude de la tension d'alimentation, un papillotement courte durée et longue durée, un creux de la tension d'alimentation et de surtensions temporaires à la fréquence industrielle, des coupures de la tension d'alimentation, des tensions transitoires, un déséquilibre de la tension d'alimentation, des harmoniques de tension, des inter-harmoniques de tension, une tension de transmission de signaux sur la tension d'alimentation, des variations rapides de tension ou RVC (acronyme anglais de « rapid voltage change »), une valeur basse et valeur haute de la tension ( dites «tension haute» et «tension basse»), une amplitude du courant, un enregistrement du courant, des harmoniques de courant, des inter-harmoniques de courant, un déséquilibre de courant. Au moins un type de données qualimétriques est calculé lors de l'étape S104. Dans un autre mode de réalisation, plusieurs types de données qualimétriques sont calculés parmi les types listés ci-dessus, e.g. des harmoniques de tensions, des harmoniques de courant et un papillotement courte durée. L'étape S104 se déroule en parallèle des étapes S100 et S102. Le calcul des données qualimétriques, lors de l'étape S104, se fait de manière synchrone de la période réseau comme décrit dans les sections 4.4 et 4.5.2 du document EN 61000-4-30 pour la Classe A.

Ainsi, le dispositif de qualimétrie Q calcule des données qualimétriques sur une période temporelle T', e.g. T'=10 minutes, et les horodate avec une heure déterminée selon l'heure UTC. Les données qualimétriques ainsi calculées et horodatées sont stockées en mémoire par le dispositif de qualimétrie Q. Un exemple de données qualimétriques calculées pour la Classe A sur la période temporelle T' est illustré dans le tableau 1 ci-dessous pour un signal électrique triphasé :

**Tableau 1- cas d'un compteur électrique**

| | |
|---|---|
| Harmoniques de tension de la phase 1 | U1 Fondamental |
| | U1 Harmonique 2 |
| | ... |
| | U1 Harmonique 50 |
| Harmoniques de tension de la phase 2 | U2 Fondamental |
| | U2 Harmonique 2 |
| | ... |
| | U2 Harmonique 50 |
| Harmoniques de tension de la phase 3 | U3 Fondamental |
| | U3 Harmonique 2 |
| | ... |
| | U3 Harmonique 50 |
| Harmoniques de courant de la phase 1 | I1 Fondamental |
| | I1 Harmonique 2 |
| | ... |
| | I1 Harmonique 50 |
| Harmoniques de courant de la phase 2 | I2 Fondamental |
| | I2 Harmonique 2 |
| | ... |
| | I2 Harmonique 50 |
| Harmoniques de courant de la phase 3 | I3 Fondamental |
| | I3 Harmonique 2 |
| | ... |
| | I3 Harmonique 50 |
| Papillotement courte durée pour chacune des 3 phases | Papillotement Pst (phase 1) |
| | Papillotement Pst (phase 2) |
| | Papillotement Pst (phase 3) |
| Horodate | Heure UTC des données |

Dans cet exemple, sur un intervalle de temps T', e.g. T'=10 minutes, le dispositif de qualimétrie Q calcule, pour chaque phase, 50 harmoniques de tension et 50 harmoniques de courant à partir d'échantillons de tensions et de courant reçus du compteur C. Bien entendu, le procédé ne se limite pas au cas de 50 harmoniques. Ainsi plus de 50 ou moins de 50 harmoniques peuvent être calculés. Pour chaque phase, un papillotement courte durée, noté Pst, est également calculé. Ces données sont horodatées avec l'heure UTC correspondant au début ou à la fin de l'intervalle de calcul. Le mode de réalisation décrit pour un signal électrique triphasé s'applique de manière similaire à un signal électrique monophasé. Dans ce cas, les données (harmoniques de tension et de courant ainsi que papillotement courte durée) sont calculées pour une seule phase.

Les calculs des données mentionnées dans le tableau ci-dessus sont effectués de la manière décrite dans la norme EN 61000-4-30 pour la Classe A.

Ainsi, dans un exemple particulier de réalisation, le dispositif de qualimétrie Q effectue une FFT (acronyme anglais de « Fast Fourier Transform ») sur les échantillons reçus en tenant compte de la fréquence d'échantillonnage indiquée dans la trame de synchronisation sur une période de temps Δtps donnée, e.g. Δtps =200 ms ce qui correspond à 10 périodes de 20 ms à 50 Hz (12 périodes de 16,67 ms à 60 Hz), afin de calculer les 50 harmoniques de tension et de courant, et le papillotement courte durée sur cette période Δtps. Puis, le dispositif de qualimétrie Q agrège, pour chaque paramètre du tableau, sur un intervalle de 150 périodes (180 périodes en 60 Hz) les résultats calculés précédemment sur 15 périodes Δtps (15 périodes Δtps également à 60 Hz). Les agrégations sont calculées en faisant des moyennes quadratiques, i.e. en calculant la racine carrée de la moyenne arithmétique du carré des valeurs d'entrée. Le dispositif de qualimétrie Q refait une moyenne quadratique sur 10 minutes pour chaque paramètre du tableau. Les résultats de ces calculs sont connus dans la littérature sous la terminologie « valeurs 10 minutes agrégées ». Le dispositif de qualimétrie Q horodate ces données qualimétriques calculées avec, par exemple, l'heure de début ou l'heure de fin de l'intervalle de temps de 10 minutes. L'exemple décrit pour un intervalle de temps de 10 minutes s'applique de manière similaire à d'autres valeurs d'intervalle de temps T'.

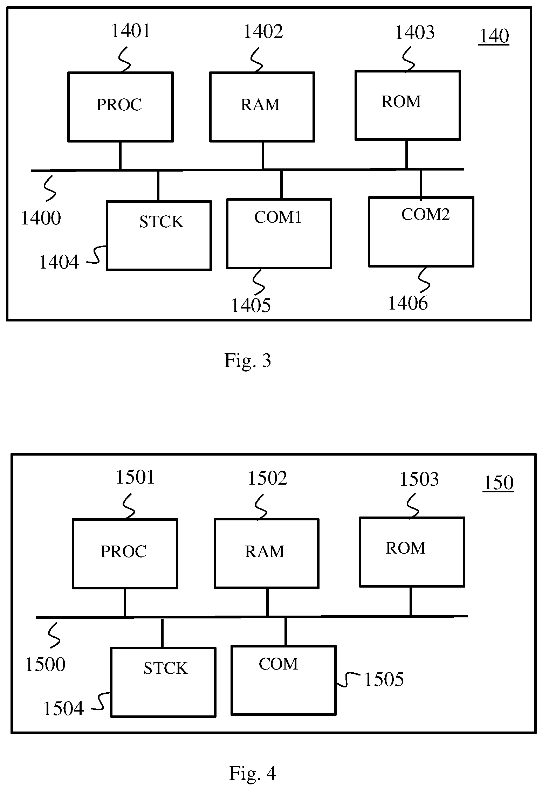

La Fig. 3 illustre schématiquement un exemple d'architecture matérielle d'un dispositif de qualimétrie 140 selon un mode particulier de réalisation. Selon l'exemple d'architecture matérielle représenté à la Fig. 3, le dispositif de qualimétrie 140 comprend alors, reliés par un bus de communication 1400 : un processeur ou CPU (« Central Processing Unit » en anglais) 1401 ; une mémoire vive RAM (« Random Access Memory » en anglais) 1402 ; une mémoire morte ROM (« Read Only Memory » en anglais) 1403 ; une unité de stockage 1404 telle qu'un disque dur ou telle qu'un lecteur de support de stockage, e.g. un lecteur de cartes SD (« Secure Digital » en anglais); au moins une première interface de communication 1405 permettant au dispositif de qualimétrie 140 d'envoyer des informations à l'entité de gestion SI et le cas échéant d'en recevoir et une seconde interface de communication 1406 permettant au dispositif de qualimétrie 140 d'envoyer ou de recevoir des informations des compteurs.

Par exemple, la première interface de communication 1405 est conforme au standard LoRa, NB-IoT, GPRS, UMTS/3G, LTE, 2G, 4G ou 5G. La seconde interface est un port série (typiquement RS-485 ou RS-422).

Le processeur 1401 est capable d'exécuter des instructions chargées dans la RAM 1402 à partir de la ROM 1403, d'une mémoire externe (non représentée), d'un support de stockage (tel qu'une carte SD), ou d'un réseau de communication. Lorsque le dispositif de qualimétrie 140 est mis sous tension, le processeur 1401 est capable de lire de la RAM 1402 des instructions et de les exécuter. Ces instructions forment un programme d'ordinateur causant la mise en œuvre, par le processeur 1401, de tout ou partie du procédé décrit en relation avec la Fig. 2.

Le procédé décrit en relation avec la Fig. 2 peut être implémenté sous forme logicielle par exécution d'un ensemble d'instructions par une machine programmable, par exemple un DSP (« Digital Signal Processor » en anglais) ou un microcontrôleur, ou être implémenté sous forme matérielle par une machine ou un composant dédié, par exemple un FPGA (« Field-Programmable Gate Array » en anglais) ou un ASIC (« Application-Specific Integrated Circuit » en anglais). En général, le dispositif de qualimétrie 140 comprend de la circuiterie électronique configurée pour mettre en œuvre le procédé décrit en relation avec la Fig. 2.

La Fig. 4 illustre schématiquement un exemple d'architecture matérielle d'un compteur 150 selon un mode particulier de réalisation. Selon l'exemple d'architecture matérielle représenté à la Fig. 4, le compteur 150 comprend alors, reliés par un bus de communication 1500 : un processeur ou CPU (« Central Processing Unit » en anglais) 1501 ; une mémoire vive RAM (« Random Access Memory » en anglais) 1502 ; une mémoire morte ROM (« Read Only Memory » en anglais) 1503 ; une unité de stockage 1504 telle qu'un disque dur ou telle qu'un lecteur de support de stockage, e.g. un lecteur de cartes SD (« Secure Digital » en anglais); au moins une interface de communication 1505 permettant au compteur 150 d'envoyer ou de recevoir des informations du dispositif de qualimétrie 140. L'interface de communication 1505 est un port série (typiquement RS-485 ou RS-422). Le compteur 150 comprend généralement une autre interface de communication non représentée sur la Fig.4 lui permettant de communiquer avec le SI soit directement (en cellulaire 2G, 3G, 4G ou 5G) soit au travers d'un concentrateur de données (typiquement en CPL ou en mode hybride, i.e. par CPL et radio), par exemple pour la relève de données de consommation.

Le processeur 1501 est capable d'exécuter des instructions chargées dans la RAM 1502 à partir de la ROM 1503, d'une mémoire externe (non représentée), d'un support de stockage (tel qu'une carte SD), ou d'un réseau de communication. Lorsque le compteur 150 est mis sous tension, le processeur 1501 est capable de lire de la RAM 1502 des instructions et de les exécuter. Ces instructions forment un programme d'ordinateur causant la mise en œuvre, par le processeur 1501, de tout ou partie du procédé décrit en relation avec la Fig. 2.

Le procédé décrit en relation avec la Fig. 2 peut être implémenté sous forme logicielle par exécution d'un ensemble d'instructions par une machine programmable, par exemple un DSP (« Digital Signal Processor » en anglais) ou un microcontrôleur, ou être implémenté sous forme matérielle par une machine ou un composant dédié, par exemple un FPGA (« Field-Programmable Gate Array » en anglais) ou un ASIC (« Application-Specific Integrated Circuit » en anglais). D'une manière générale, le compteur 150 comprend de la circuiterie électronique configurée pour mettre en œuvre le procédé décrit en relation avec la Fig. 2.

## Revendications

1. Un procédé de calcul de données qualimétriques par un dispositif de qualimétrie (Q) en communication avec un compteur (C) d'un réseau électrique au travers d'une liaison série, ledit procédé comprenant les étapes suivantes mises en œuvre par le dispositif de qualimétrie (Q):
- Recevoir (S100) à un instant t une trame de synchronisation en provenance dudit compteur (C), ladite trame de synchronisation comprenant un identifiant indiquant que ladite trame est une trame de synchronisation, un numéro de série du compteur (C), une information représentative du type de compteur (C), une information indiquant si le courant de neutre est mesuré par ledit compteur (C), une fréquence et un type d'échantillonnage, une fréquence dudit réseau électrique, et appliquer un décalage temporel Δt à l'instant t pour déterminer le début d'une période (T) d'une horloge du compteur (C) en calculant t-Δt pour recaler une horloge du dispositif de qualimétrie (Q) sur l'horloge du compteur (C), le décalage temporel Δt correspondant au décalage entre un début effectif de la période (T) de l'horloge du compteur et la réception de la trame de synchronisation par le dispositif de qualimétrie (Q) ;
- Recevoir (S102), pendant la période (T), N trames d'échantillons en provenance dudit compteur (C), N étant un entier positif, chaque trame d'échantillons comprenant un identifiant indiquant que ladite trame est une trame d'échantillons, un numéro de trame d'échantillons et des échantillons de tension et de courant pour au moins une phase ; et
- Calculer (S104) des données qualimétriques à partir des informations comprises dans ladite trame de synchronisation et dans au moins une partie desdites N trames d'échantillons.

2. Le procédé de calcul selon la revendication 1, dans lequel ladite trame de synchronisation comprend en outre une information représentative d'une heure UTC.

3. Le procédé de calcul selon la revendication 1 ou 2, dans lequel, lesdites trames sont des trames conformes au protocole HDLC.

4. Le procédé de calcul selon l'une des revendications 1 à 3, dans lequel lesdites données qualimétriques calculées appartiennent à l'ensemble des types données qualimétriques comprenant : une fréquence industrielle, une amplitude de tension d'alimentation, un papillotement courte durée, un papillotement longue durée, un creux de la tension d'alimentation et de surtensions temporaires à fréquence industrielle, des coupures de la tension d'alimentation, des tensions transitoires, un déséquilibre de la tension d'alimentation, des harmoniques de tension, des inter-harmoniques de tension, une tension de transmission de signaux sur la tension d'alimentation, des variations rapides de tension, une valeur basse et une valeur haute de la tension, une amplitude du courant, un enregistrement du courant, des harmoniques de courant, des inter-harmoniques de courant, et un déséquilibre de courant.

5. Un procédé de calcul de données qualimétriques par un dispositif de qualimétrie selon la revendication 7, en communication avec un compteur (C) d'un réseau électrique au travers d'une liaison série, ledit procédé comprenant les étapes suivantes mises en œuvre par le compteur (C) :
- Envoyer (S100) à un instant t une trame de synchronisation audit dispositif de qualimétrie (Q), ladite trame de synchronisation comprenant un identifiant indiquant que ladite trame est une trame de synchronisation, un numéro de série du compteur (C), une information représentative du type de compteur (C), une information indiquant si le courant de neutre est mesuré par ledit compteur (C), une fréquence et un type d'échantillonnage et une fréquence dudit réseau électrique ; et
- Envoyer (S102), pendant une période (T), N trames d'échantillons audit dispositif de qualimétrie (Q), N étant un entier positif, chaque trame d'échantillons comprenant un identifiant indiquant que ladite trame est une trame d'échantillons, un numéro de trame d'échantillons et des échantillons de tension et de courant pour au moins une phase.

6. Le procédé de calcul selon la revendication 5, dans lequel ladite trame de synchronisation comprend en outre une information représentative d'une heure UTC.

7. Un dispositif qualimétrique configuré pour être en communication avec un compteur (C) d'un réseau électrique au travers d'une liaison série, ledit dispositif qualimétrique comprenant de la circuiterie électronique configurée pour :
- Recevoir (S100) à un instant t une trame de synchronisation en provenance dudit compteur (C), ladite trame de synchronisation comprenant un identifiant indiquant que ladite trame est une trame de synchronisation, un numéro de série du compteur (C), une information représentative du type de compteur (C), une information indiquant si le courant de neutre est mesuré par ledit compteur (C), une fréquence et un type d'échantillonnage, une fréquence dudit réseau électrique, et appliquer un décalage temporel Δt à l'instant t pour déterminer le début d'une nouvelle période (T) d'une horloge du compteur (C) en calculant t-Δt pour recaler une horloge du dispositif de qualimétrie (Q) sur l'horloge du compteur (C), le décalage temporel Δt correspondant au décalage entre un début effectif de la période (T) de l'horloge du compteur et la réception de la trame de synchronisation par le dispositif de qualimétrie (Q);
- Recevoir (S102), pendant la période (T), N trames d'échantillons en provenance dudit compteur (C), N étant un entier positif, chaque trame d'échantillons comprenant un identifiant indiquant que ladite trame est une trame d'échantillons, un numéro de trame d'échantillons et des échantillons de tension et de courant pour au moins une phase ; et
- Calculer (S104) des données qualimétriques à partir des informations comprises dans ladite trame de synchronisation et dans au moins une partie desdites N trames d'échantillons.

8. Un compteur (C) d'un réseau électrique configuré pour être en communication au travers d'une liaison série avec un dispositif qualimétrique selon la revendication 7 configuré pour calculer des données qualimétriques, ledit compteur (C) comprenant de la circuiterie électronique configurée pour :
- Envoyer (S100) à un instant t une trame de synchronisation audit dispositif de qualimétrie (Q), ladite trame de synchronisation comprenant un identifiant indiquant que ladite trame est une trame de synchronisation, un numéro de série du compteur (C), une information représentative du type de compteur (C), une information indiquant si le courant de neutre est mesuré par ledit compteur (C), une fréquence et un type d'échantillonnage et une fréquence dudit réseau électrique ; et
- Envoyer (S102), pendant un période (T), N trames d'échantillons audit dispositif de qualimétrie (Q), N étant un entier positif, chaque trame d'échantillons comprenant un identifiant indiquant que ladite trame est une trame d'échantillons, un numéro de trame d'échantillons et des échantillons de tension et de courant pour au moins une phase.

9. Un système (100) comprenant un dispositif qualimétrique (Q) selon la revendication 7 en communication au travers d'une liaison série avec un compteur (C) selon la revendication 8.

10. Un produit programme d'ordinateur comprenant des instructions pour mettre en œuvre le procédé de calcul de données qualimétriques selon l'une quelconque des revendications 1 à 6, lorsque ledit programme est exécuté par au moins un processeur.

11. Un support de stockage stockant un programme d'ordinateur comprenant des instructions pour mettre en œuvre le procédé de calcul de données qualimétriques selon l'une quelconque des revendications 1 à 6 lorsque ledit programme est exécuté par au moins un processeur.

## Patentansprüche

1. Verfahren zur Berechnung qualimetrischer Daten durch eine Qualimetrievorrichtung (Q), die mit einem Zähler (C) eines Stromnetzes durch eine serielle Verbindung in Kommunikation steht, wobei das Verfahren die folgenden Schritte umfasst, die von der Qualimetrievorrichtung (Q) durchgeführt werden:
- Empfangen (S100) eines Synchronisationsrahmens vom Zähler (C) zu einem Zeitpunkt t, wobei der Synchronisationsrahmen eine Kennung, die angibt, dass der Rahmen ein Synchronisationsrahmen ist, eine Seriennummer des Zählers (C), eine Information, die für den Typ des Zählers (C) steht, eine Information, die angibt, ob der Neutralleiterstrom durch den Zähler (C) gemessen wird, eine Abtastfrequenz und -art, eine Frequenz des Stromnetzes umfasst, und Anwenden eines Zeitversatzes Δt auf den Zeitpunkt t, um den Beginn einer Periode (T) eines Taktgebers des Zählers (C) durch Berechnung von t-Δt zu bestimmen, um einen Taktgeber der Qualimetrievorrichtung (Q) auf den Taktgeber des Zählers (C) einzustellen, wobei der Zeitversatz Δt dem Versatz zwischen einem tatsächlichen Beginn der Periode (T) des Taktgebers des Zählers und dem Empfang des Synchronisationsrahmens durch die Qualimetrievorrichtung (Q) entspricht;
- Empfangen (S102) von N Abtastwerterahmen vom Zähler (C) während der Periode (T), wobei N eine positive Ganzzahl ist, wobei jeder Abtastwerterahmen eine Kennung, die angibt, dass der Rahmen ein Abtastwerterahmen ist, eine Abtastwerterahmen-Nummer und Spannungs- und Stromabtastwerte für wenigstens eine Phase umfasst; und
- Berechnen (S104) der qualimetrischen Daten aus den Informationen, die in dem Synchronisationsrahmen und wenigstens einem Abschnitt der N Abtastwerterahmen enthalten sind.

2. Berechnungsverfahren nach Anspruch 1, wobei der Synchronisationsrahmen ferner eine Information umfasst, die für eine UTC-Zeit steht.

3. Berechnungsverfahren nach Anspruch 1 oder 2, wobei die Rahmen dem HDLC-Protokoll entsprechende Rahmen sind.

4. Berechnungsverfahren nach einem der Ansprüche 1 bis 3, wobei die berechneten qualimetrischen Daten zu dem Satz der Typen qualimetrischer Daten gehören, der Folgendes umfasst: eine Netzfrequenz, eine Versorgungsspannungsamplitude, einen Kurzzeitflicker, einen Langzeitflicker, einen Einbruch der Versorgungsspannung und vorübergehende Überspannungen bei Netzfrequenz, Ausfälle der Versorgungsspannung, transiente Spannungen, eine Unsymmetrie der Versorgungsspannung, Spannungsharmonische, Spannungs-Zwischenharmonische, eine Signalübertragungsspannung auf der Versorgungsspannung, schnelle Spannungsschwankungen, ein niedriger und ein hoher Spannungswert, eine Stromamplitude, eine Stromaufzeichnung, Stromharmonische, Stromzwischenharmonische und eine Stromunsymmetrie.

5. Verfahren zur Berechnung qualimetrischer Daten durch eine Qualimetrievorrichtung nach Anspruch 7, die mit einem Zähler (C) eines Stromnetzes durch eine serielle Verbindung in Kommunikation steht, wobei das Verfahren die folgenden Schritte umfasst, die vom Zähler (C) durchgeführt werden:
- Senden (S100) eines Synchronisationsrahmens an die Qualimetrievorrichtung (Q) zu einem Zeitpunkt t, wobei der Synchronisationsrahmen eine Kennung, die angibt, dass der Rahmen ein Synchronisationsrahmen ist, eine Seriennummer des Zählers (C), eine Information, die für den Typ des Zählers (C) steht, eine Information, die angibt, ob der Neutralleiterstrom durch den Zähler (C) gemessen wird, eine Abtastfrequenz und -art und eine Frequenz des Stromnetzes umfasst; und
- Senden (S102) von N Abtastwerterahmen an die Qualimetrievorrichtung (Q) während einer Periode (T), wobei N eine positive Ganzzahl ist, wobei jeder Abtastwerterahmen eine Kennung, die angibt, dass der Rahmen ein Abtastwerterahmen ist, eine Abtastwerterahmen-Nummer und Spannungs- und Stromabtastwerte für wenigstens eine Phase umfasst.

6. Berechnungsverfahren nach Anspruch 5, wobei der Synchronisationsrahmen ferner eine Information umfasst, die für eine UTC-Zeit steht.

7. Qualimetrievorrichtung, die dazu ausgebildet ist, mit einem Zähler (C) eines Stromnetzes durch eine serielle Verbindung in Kommunikation zu stehen, wobei die Qualimetrievorrichtung eine elektronische Schaltung umfasst, die für Folgendes ausgebildet ist:
- Empfangen (S100) eines Synchronisationsrahmens vom Zähler (C) zu einem Zeitpunkt t, wobei der Synchronisationsrahmen eine Kennung, die angibt, dass der Rahmen ein Synchronisationsrahmen ist, eine Seriennummer des Zählers (C), eine Information, die für den Typ des Zählers (C) steht, eine Information, die angibt, ob der Neutralleiterstrom durch den Zähler (C) gemessen wird, eine Abtastfrequenz und -art, eine Frequenz des Stromnetzes umfasst, und Anwenden eines Zeitversatzes Δt auf den Zeitpunkt t, um den Beginn einer neuen Periode (T) eines Taktgebers des Zählers (C) durch Berechnung von t-Δt zu bestimmen, um einen Taktgeber der Qualimetrievorrichtung (Q) auf den Taktgeber des Zählers (C) einzustellen, wobei der Zeitversatz Δt dem Versatz zwischen einem tatsächlichen Beginn der Periode (T) des Taktgebers des Zählers und dem Empfang des Synchronisationsrahmens durch die Qualimetrievorrichtung (Q) entspricht;
- Empfangen (S102) von N Abtastwerterahmen vom Zähler (C) während der Periode (T), wobei N eine positive Ganzzahl ist, wobei jeder Abtastwerterahmen eine Kennung, die angibt, dass der Rahmen ein Abtastwerterahmen ist, eine Abtastwerterahmen-Nummer und Spannungs- und Stromabtastwerte für wenigstens eine Phase umfasst; und
- Berechnen (S104) der qualimetrischen Daten aus den Informationen, die in dem Synchronisationsrahmen und wenigstens einem Abschnitt der N Abtastwerterahmen enthalten sind.

8. Zähler (C) eines Stromnetzes, der dazu ausgebildet ist, durch eine serielle Verbindung mit einer Qualimetrievorrichtung nach Anspruch 7 in Kommunikation zu stehen, die dazu ausgebildet ist, qualimetrische Daten zu berechnen, wobei der Zähler (C) eine elektronische Schaltung umfasst, die für Folgendes ausgebildet ist:
- Senden (S100) eines Synchronisationsrahmens an die Qualimetrievorrichtung (Q) zu einem Zeitpunkt t, wobei der Synchronisationsrahmen eine Kennung, die angibt, dass der Rahmen ein Synchronisationsrahmen ist, eine Seriennummer des Zählers (C), eine Information, die für den Typ des Zählers (C) steht, eine Information, die angibt, ob der Neutralleiterstrom durch den Zähler (C) gemessen wird, eine Abtastfrequenz und -art und eine Frequenz des Stromnetzes umfasst; und
- Senden (S102) von N Abtastwerterahmen an die Qualimetrievorrichtung (Q) während einer Periode (T), wobei N eine positive Ganzzahl ist, wobei jeder Abtastwerterahmen eine Kennung, die angibt, dass der Rahmen ein Abtastwerterahmen ist, eine Abtastwerterahmen-Nummer und Spannungs- und Stromabtastwerte für wenigstens eine Phase umfasst.

9. System (100), das eine Qualimetrievorrichtung (Q) nach Anspruch 7 umfasst, die durch eine serielle Verbindung mit einem Zähler (C) nach Anspruch 8 in Kommunikation steht.

10. Computerprogrammprodukt, das Anweisungen zur Durchführung des Verfahrens zur Berechnung qualimetrischer Daten nach einem der Ansprüche 1 bis 6 bei Ausführung des Programms durch wenigstens einen Prozessor umfasst.

11. Speichermedium, das ein Computerprogramm speichert, das Anweisungen zur Durchführung des Verfahrens zur Berechnung qualimetrischer Daten nach einem der Ansprüche 1 bis 6 bei Ausführung des Programms durch wenigstens einen Prozessor umfasst.

## Claims

1. A method for calculating qualimetric data by a qualimetry device (Q) in communication with a meter (C) of an electricity network through a serial connection, said method comprising the following steps performed by the qualimetry device (Q):
- receiving (S100) at a time t a synchronisation frame coming from said meter (C), said synchronisation frame comprising an identifier indicating that said frame is a synchronisation frame, a serial number of the meter (C), information representing the type of meter (C), information indicating whether the neutral current is being measured by said meter (C), a sampling and frequency type, and a frequency of said electricity network, and applying a time difference Δt at the time t to determine the start of a period (T) of a clock of the meter (C) by calculating t-Δt to reset a clock of the qualimetry device (Q) to the clock of the meter (C), the time difference Δt corresponding to the difference between an actual start of the period (T) of the clock of the meter and the reception of the synchronisation frame by the qualimetry device (Q);
- receiving (S102), during the period (T), N frames of samples coming from said meter (C), N being a positive integer, each frame of samples comprising an identifier indicating that said frame is a frame of samples, and a number of a frame of samples and of voltage and current samples for at least one phase; and
- calculating (S104) qualimetric data from the information included in said synchronisation frame and in at least some of said N frames of samples.

2. The calculation method according to claim 1, wherein said synchronisation frame furthermore comprises information representing a UTC time.

3. The calculation method according to claim 1 or 2, wherein said frames are frames conforming to the HDLC protocol.

4. The calculation method according to one of claims 1 to 3, wherein said calculated qualimetric data belong to all the types of qualimetric data comprising: an industrial frequency, a supply voltage amplitude, a short-duration flicker, a long-duration flicker, a trough of the supply voltage and of temporary industrial-frequency overvoltages, breaks in the supply voltage, transient voltages, an imbalance in the supply voltage, voltage harmonics, voltage interharmonics, a signal transmission voltage on the supply voltage, rapid voltage variations, a low voltage value and a high voltage value, an amplitude of the current, a recording of the current, current harmonics, current interharmonics, and a current imbalance.

5. A method for calculating qualimetric data by a qualimetry device according to claim 7, in communication with a meter (C) of an electricity network through a serial connection, said method comprising the following steps performed by the meter (C):
- sending (S100) a synchronisation frame at a time t to said qualimetry device (Q), said synchronisation frame comprising an identifier indicating that said frame is a synchronisation frame, a serial number of the meter (C), information representing the type of meter (C), information indicating whether the neutral current is being measured by said meter (C), a sampling and frequency type, and a frequency of said electricity network, and
- sending (S102), during a period (T), N frames of samples to said qualimetry device (Q), N being a positive integer, each frame of samples comprising an identifier indicating that said frame is a frame of samples, and a number of a frame of samples and of voltage and current samples for at least one phase.

6. The calculation method according to claim 5, wherein said synchronisation frame furthermore comprises information representing a UTC time.

7. A qualimetric device configured to be in communication with a meter (C) of an electricity network through a serial connection, said qualimetric device comprising electronic circuitry configured to:
- receive (S100) at a time t a synchronisation frame coming from said meter (C), said synchronisation frame comprising an identifier indicating that said frame is a synchronisation frame, a serial number of the meter (C), information representing the type of meter (C), information indicating whether the neutral current is being measured by said meter (C), a sampling and frequency type, and a frequency of said electricity network, and apply a time difference Δt at the time t to determine the start of a period (T) of a clock of the meter (C) by calculating t-Δt to reset a clock of the qualimetry device (Q) to the clock of the meter (C), the time difference Δt corresponding to the difference between an actual start of the period (T) of the clock of the meter and the reception of the synchronisation frame by the qualimetry device (Q);
- receive (S102), during the period (T), N frames of samples coming from said meter (C), N being a positive integer, each frame of samples comprising an identifier indicating that said frame is a frame of samples, and a number of a frame of samples and of voltage and current samples for at least one phase; and
- calculate (S104) qualimetric data from the information included in said synchronisation frame and in at least some of said N frames of samples.

8. A meter (C) of an electricity network configured to be in communication through a serial connection with a qualimetric device according to claim 7 configured to calculate qualimetric data, said meter (C) comprising electronic circuitry configured to:
- send (S100) a synchronisation frame at a time t to said qualimetry device (Q), said synchronisation frame comprising an identifier indicating that said frame is a synchronisation frame, a serial number of the meter (C), information representing the type of meter (C), information indicating whether the neutral current is being measured by said meter (C), a sampling and frequency type, and a frequency of said electricity network, and
- send (S102), during a period (T), N frames of samples to said qualimetry device (Q), N being a positive integer, each frame of samples comprising an identifier indicating that said frame is a frame of samples, and a number of a frame of samples and of voltage and current samples for at least one phase.

9. A system (100) comprising a qualimetric device (Q) according to claim 7 in communication through a serial connection with a meter (C) according to claim 8.

10. A computer program product comprising instructions for implementing the method for calculating qualimetric data according to any one of claims 1 to 6, when said program is executed by at least one processor.

11. A storage medium storing a computer program comprising instructions for implementing the method for calculating qualimetric data according to any one of claims 1 to 6 when said program is executed by at least one processor.
